# EUROPEAN PATENT SPECIFICATION

(11) **EP 2 033 000 B1**
(45) Date of publication and mention of the grant of the patent: **12.08.2015**
(21) Application number: 07748609.0
(22) Date of filing: 20.06.2007
(51) Int. Cl.: G01R 31/12, G01R 31/08

(54) **A METHOD AND A DEVICE FOR DIAGNOSING AN ON-LINE HIGH VOLTAGE COMPONENT**
VERFAHREN UND EINRICHTUNG ZUM DIAGNOSTIZIEREN EINER ONLINE-HOCHSPANNUNGSKOMPONENTE
PROCÉDÉ ET DISPOSITIF POUR DIAGNOSTIQUER UN COMPOSANT HAUTE TENSION EN LIGNE

(30) Priority: 26.06.2006 SE 0601386
(43) Date of publication of application: 11.03.2009
(73) Proprietor: Swedish Neutral AB, 196 31 Kungsängen (SE)
(72) Inventor: WINTER, Klaus, S-196 37 Kungsängen (SE)
(74) Representative: Wihlsson, Joakim Per Magnus
(86) International application number: PCT/SE2007/050449
(87) International publication number: WO 2008/002259

(56) References cited:
- WO-A2-2004/013642
- JP-A- 10 062 485
- JP-A- 10 062 485
- JP-A- 58 044 364
- US-A1- 2003 038 016
- US-A1- 2003 038 016
- US-B1- 6 313 640

## Description

### FIELD OF THE INVENTION

The invention relates to a method for facilitating inspection of a high voltage component during its operation, and a device adapted to be connected with a high voltage system for facilitating inspection of a high voltage component during its operation.

### PRIOR ART

A high voltage component, for example a high voltage conductor, a transformer, a switchgear or similar, often comprises an electrical conductor, usually of a metal, and an insulating cover arranged around the electrical conductor. Due to the high voltage a high electric field arise in the insulation, wherein weak currents may arise inside the insulation. In particular weak currents may arise in possible inhomogeneous parts of the insulation. The weak current slowly destroys the material so that the inhomogeneous part is enlarged and/or changed. Thus the current becomes even stronger, which further destroys the material in the insulation. After some time a so called partial discharge results, and the defect in the insulation grows exponentially. Eventually a disruptive discharge through the insulation result and the high voltage component is shortcut. Partial discharges and disruptive discharges constitute a great problem for high voltage systems since the system must be shut down when a disruptive discharge has occurred to avoid damages and to allow reparation.

It is known to inspect high voltage conductors for signs of partial discharges in order to prevent the risk of disruptive discharges.

Such an inspection of, among others, high voltage conductors for distribution of electrical power, includes that an inspection team drives to the location, which is to be inspected, with a truck, that the high voltage conductor, which is to be inspected, is temporarily shut down, and that an inspection device is connected to the high voltage conductor. The inspection device comprises a high voltage generator applying a voltage over the conductor, after which the conductor is inspected for any partial discharges. One problem with this is that only a very small part of the high voltage conductor may be measured and that the measurement must be carried out in the field. For distribution systems comprising several kilometers of high voltage conductors this is in practice impossible to do in order to completely prevent disruptive discharges. Furthermore the inspection equipment is very expensive and must be brought to the location on which the inspection is to take place by a truck.

In patent document WO 2004/013642 a method is shown in which a detector is connected to a screen arranged round a high voltage cable. The screen is a casing of an electrically conducting material held at earth potential in order to trap the electrical field inside the high voltage cable. During a partial discharge a short electric pulse appear in the screen. The method comprises registering pulses at both ends of the cable and comparing the appearances of the pulses with each other relative a common time frame. Departing from the times at which the pulses were measured at the two ends of the cable the location for the partial discharge may be estimated. In this manner it is possible to inspect the appearance of partial discharges in the cable while the cable is still operational. Furthermore it is no longer necessary to travel to the location at which the fault has occurred, but it is possible to monitor the entire cable at the same time.

JP 58 044 364 discloses a measurement technique for a so-called off-line partial discharge measurement, whereby the investigated object, such as a cable, is disconnected during the partial discharge measurement. The investigated object is supplied with DC voltage during the measurement.

One problem with both these inspection methods is that an inhomogenity or a defect in a cable is discovered only after a partial discharge has occurred. When the inhomogenity or defect is of such magnitude that a partial discharge has occurred the material degrades very quickly. This means that the time for longterm planning is very short when using the methods above. Usually it only takes a few hours or days from the appearance of a partial discharge until a full disruptive discharge occurs. Thus the possibility to prevent the effect from a disruptive discharge is small, since it usually takes longer time to change a defective cable.

### SUMMARY OF THE INVENTION

One object of the present invention is to facilitate the handling of a high voltage component in relation to partial discharges in the component. According to a first aspect this object is achieved with a method according to claim 1. According to a second aspect this object is achieved with a device constructed in accordance with claim 9.

By displacing the common potential for the high voltage conductors during the operation of the high voltage system the possibility to change the potential difference between a component and the earth potential, without affecting the operation of the high voltage system itself, is achieved. The high voltage system is not affected since the loads in the system are connected between the phases, so that the common potential in relation to earth does not affect the result. However, by changing the potential difference between a component and earth the strength of the electrical field in the insulation of the component is affected, which can be used to improve the handling of partial discharges through the insulation.

The high voltage system may be any form of system comprising two or more phases. A high voltage system is a system in which voltages from 1 kV and upwards are present. Usually the voltage in the system is 10-400 kV. Preferably the high voltage system is an alternating current system comprising three phases. The high voltage system may for example be a distribution system, a generator system or a user system. Preferably the high voltage system is constituted by high voltage conductors for distribution of electrical power. The high voltage component connected with the high voltage system may be a generator, a transformer or an electric engine. Preferably the high voltage component is a high voltage conductor or a high voltage cable.

Preferably the voltage in the system is an alternating current, wherein the voltage oscillates around an average potential. In normal operation the average potential is usually zero. The voltage usually oscillates in the form of a sinus curve having a maximum potential. A partial discharge is obtained when the absolute value of the voltage is sufficiently high, thus usually at the maximum potential.

Preferably any load in the high voltage system is coupled between the phases and not between the phases and earth. Thus a displacement of the common potential will not affect the voltage over the loads. Hence the method can be performed even though the high voltage system is operational.

According to one embodiment the invention comprises displacing the potential so that the potential difference between the defective high voltage component and the earth potential decreases, if a partial discharge is detected for the high voltage component. Preferably the common potential is displaced so that the potential of the defective high voltage component is as close to the earth potential, so as to end any partial discharges. Hence the maximum potential in the defective high voltage component decreases so that the current through the inhomogenity decreases, meaning that the time to a disruptive discharge destroying the high voltage component increases. Thus a longer time for maintenance is achieved, so that the high voltage system may continue its operation for a longer period.

According to one embodiment the common potential is displaced so that the maximum potential difference between the high voltage component to be inspected and the earth potential increases, wherein any appearances of partial discharges in the insulating cover of the high voltage component is inspected. When the maximum potential difference between a high voltage component, which is to be inspected, and the earth potential increases the potential difference across any inhomogenity in the insulation around the high voltage component increases as well, so that a partial discharge is obtained earlier, even if the inhomogenity is too small for a partial discharge to be obtained during normal circumstances. By inspecting any appearances of partial discharges in the insulating cover of the high voltage component inhomogenities may thus be discovered before partial discharges have developed in the inhomogenities at normal operating conditions. Thus the detection ability of the inspection increases, in that inhomogenities, which are not yet sufficiently large to allow partial discharges, can be found. Thus defects can also be discovered for example in the winding of a generator, engine or transformer. Thus the timespan for long-time planning increases so that it is much simpler to plan the maintenance of the component.

The partial discharge can be discovered by using any inspection method, working during progressing operation. Preferably the method comprises detection of electrical pulses in the high voltage component, which is to be inspected, which pulses originate from a partial discharge in the insulation of the high voltage component.

Preferably the common potential is displaced so that the maximum potential difference between the high voltage component to be inspected and the earth potential increases to a level required for the inspection. Preferably the common potential is displaced so that the maximum potential between the high voltage component to be inspected and the earth potential, increases to more than or equal to one and a half times their original maximum potential. Hence it is ensured that any inhomogenities are discovered a sufficient time ahead. Preferably the common potential is displaced so that the potential difference between the high voltage component to be inspected and the earth potential does not increase more than the maximum potential for an over voltage protection connected to the high voltage system. Thus it is ensured that the maximum potential does not increase to such a degree that the insulation around the high voltage component is unnecessarily damaged. Preferably the common potential is therefore also displaced during a time interval shorter than three minutes. Preferably the interval is shorter than one minute and most preferably the time interval is shorter than thirty seconds. Hence the increased potential does not cause an unacceptable negative action on the smaller inhomogenities present in the insulation. An inspection for partial discharges may today be carried out very quickly wherein it is unnecessary to subject the high voltage component for high voltages during a long time, since the inhomogenities then may be enlarged.

According to one embodiment the common potential is displaced by feeding a voltage and/or current to the high voltage system. Thus the common potential may easily be displaced with good supervision and control of the displacement. Preferably the common potential is displaced by feeding a voltage to the zero point of the high voltage system. Hence it is easier to control the displacement since the displacement of the common potential becomes the same as the fed voltage. Preferably the common potential is displaced by feeding an alternating current to the high voltage system. By feeding the high voltage system with an alternating current different effects may be obtained depending on the phase angle with which the alternating current is fed. Preferably the fed alternating current is mainly of the same size as the alternating current in the high voltage conductors.

In one embodiment the high voltage system is fed with an alternating current being in phase with the alternating current in one of the high voltage conductors. Thus the maximum potential of one high voltage component connected to that conductor will increase, since the alternating voltages are added with each other. Hence this high voltage component may easily be inspected for the presence of partial discharges. In a three-phase system the voltage of the other phases also decreases, wherein it is simple to determine from which phase any partial discharge is originating.

In another preferred embodiment the high voltage system is fed with an alternating current being in opposite phase relative to the alternating current through one high voltage component, which is not to be inspected. Thus the maximum potential of this high voltage component relative to earth decreases, which decreases the risk that this high voltage component will be degraded. At the same time the maximum potential of all the other high voltage conductors or -components increases, wherein these high voltage components may be inspected at the same time. Preferably the common potential is displaced so that the potential difference between a second high voltage component, which is not to be inspected, and the earth potential is less than, preferably less than half of, the maximum potential during normal operation of the high voltage component. Preferably the common potential is thus displaced so that the potential of the second high voltage component, which is not to be inspected, is close to the earth potential. By feeding an alternating current which is either in opposite phase or have the same phase as one of the phases in the high voltage system the feeding and displacement of the potential may be controlled in a very simple manner.

According to one embodiment the high voltage component comprises a conducting screen arranged around the component, which screen is held substantially at earth potential, wherein an electrical pulse in the conducting screen is detected. Thus partial discharges may be detected by online monitoring of any electrical pulses in the conducting screen. Preferably the inspection is carried out in a corresponding manner as is described in the document WO 2004/013642. Hence it is very simple to displace the common potential and automatically monitor and detect electrical pulses in the conducting screen of the component to be inspected at regular intervals, for example once per week. This in order to detect any presence of small inhomogenities in advance, which in time may lead to enlarged inhomogenities and partial discharges. Thus a good long-time planning with a lot of time available for reparation of the high voltage component is achieved. By using the method according to WO 2004/013642 the location for the inhomogenity may also be estimated.

According to a further embodiment the earth current between the high voltage system and earth is at least partially compensated for by use of a reactor. By using a reactor during the displacement of the common potential the current for achieving the displacement of the potential may in part be taken from the generators of the high voltage system itself, which is much more efficient than to feed the high voltage system with a high voltage from a voltage generator. A high voltage generator may otherwise risk to use tremendous amounts of current and may need to be very powerful.

### SHORT DESCRIPTION OF ATTACHED DRAWINGS

The invention is now to be explained as a non-limiting example of the invention and with reference to the attached drawings.
Fig. 1 shows a high voltage system and a device for facilitating an inspection of a high voltage conductor connected with the high voltage system.
Fig. 2 shows a view of a defective high voltage conductor in cross section.
Fig. 3 a-b show two examples of how the common potential may be displaced.
Fig. 4 shows a method according to the invention.

### DETAILED DESCRIPTION

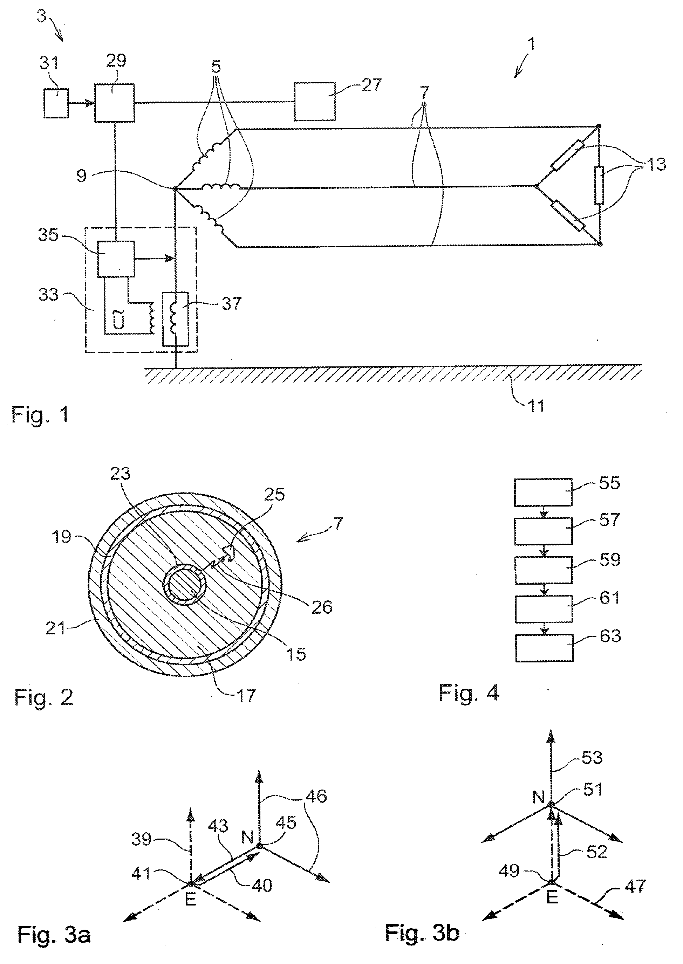

In figure 1 a high voltage system 1 and a device 3 according to the invention are shown. The high voltage system 1 comprises three generators 5 arranged to each generate an alternating current. The generated alternating currents are displaced in phase 120° relative to each other and have mainly the same amplitude, so that the alternating currents added together become substantially zero during normal operation. The generators 5 are each connected to its own high voltage component 7, in this example its own high voltage conductor 7, arranged to conduct one alternating current phase respectively. The high voltage conductors 7 are connected to each other in a zero point 9. Due to the design of the high voltage system the voltage in the zero point 9 is in this example close to the potential in the ground 11 having earth potential. The zero point 9 is furthermore connected with the ground 11.

In figure 1 it is shown that the high voltage conductors 7 are located above ground, but the high voltage conductors may just as well be cables dug down beneath the ground. The high voltage system 1 further comprises three loads 13, in which the electric power generated by the generators 5 drives some form of work. The loads 13 may for example be engines, a transformer, a machine or some other item driven by electricity. The loads 13 may also in themselves contain high voltage conductors. The loads 13 are in this example connected between two high voltage conductors 7 each, wherein the loads thus are connected between two phases.

In figure 2 a cross-section of a high voltage conductor 7 in figure 1 is shown. The high voltage conductor 7 comprises an inner electrical conductor 15, an insulating cover 17 and an electrically conducting screen 19 enclosing the insulating cover 17, and which is further held at earth potential. The screen 19 thus traps the electrical field generated around the inner conductor 15. The high voltage conductor 7 further comprises an outer cover 21 arranged to protect the high voltage conductor 7 from for example mechanical wear, and a thin layer of increased conductivity 23 arranged next to the inner conductor 15 in order to smooth out any spikes in the electrical field around the inner conductor 15, which may depend on unevennesses on the surface of the inner conductor.

In figure 2 it is also shown that the insulating cover 17 comprises an inhomogenity or defect 25. The inhomogenity 25 may depend on a manufacturing fault, such as too high moisture, or a damage, such as a mechanical thrust or a quick temperature change. Due to the high fields created inside the high voltage conductor 7 a weak current may be generated in or around the inhomogenity 25. In time the weak current will in turn enlarge and/or enhance the inhomogenity 25, so that an even stronger current is generated through the inhomogenity 25. Thus a degrading effect has been created which slowly destroys the insulating cover 17 in the high voltage conductor 7, until a partial discharge 26 takes place. During the partial discharge 26 a current is conducted to the inhomogenity 25 from the inner conductor. Thereafter an avalanche type degradation of the inhomogenity 25 takes place, so that after a short time a full break-through through the insulating cover 17 occurs. The high voltage conductor 7 may then, for example if the high voltage conductor 7 is dug into the ground, be shortcut relative to the ground so that an earth fault is created. The high voltage conductor 7 must thus be taken out of operation to avoid damages and to be repaired.

In figure 1 it is shown that the device 3 according to the invention is adapted to be connected to the high voltage system 1. The device 3 is in this example divided into several units, which are adapted to communicate with each other, but the device may also be designed as one single unit. In this example the device 3 comprises a sensor 27 adapted to sense any partial discharges and a control device 29 adapted to control the device 3. The control device 29 comprises in this example a computer and a computer readable medium 31 having a computer program written thereon, wherein the computer is adapted to read the computer readable medium 31, to download the computer program into a work memory in the computer and to execute the computer program. The computer program thus controls the device 3 to perform the steps of the method according to the invention.

The device 3 comprises a potential displacement device 33 adapted to achieve a displacement of the common potential of the high voltage system. In this example the device is adapted to displace the common potential so that the potential difference between a high voltage component and the earth potential decreases, if a partial discharge has been detected in that high voltage component. In this example the device is adapted to displace the common potential so that the potential difference of a high voltage component is close to the earth potential, if a partial discharge is detected in that high voltage component. Thus the lifetime for the component will increase, since the voltage over the inhomogenity decreases.

The device 3 is further adapted to facilitate an inspection of a component by achieving a displacement of the common potential for the high voltage system, so that a maximum potential difference between the high voltage conductor 7 to be inspected by the sensor 27 and the earth potential increases. In this case the potential displacement device 33 is adapted to achieve a displacement of the common potential in the zero point 9. By the device 3 being adapted to displace the common potential in the zero point 9, so that the voltage between the high voltage conductor 7 which is to be inspected and earth increases, the voltage over any inhomogenities 25 in the insulating cover 17 of the high voltage conductor 7 also increases. Thus the current through the inhomogenity 25 increases so that a partial discharge occurs, even if a partial discharge would not have occurred at normal voltage over the inhomogenity. Thus the partial discharge happens earlier so that the inhomogenity 25 is detected much earlier than when detecting any partial discharges during a normal operating potential.

In this example the high voltage components 7, which are to be inspected, are constituted by said high voltage conductors 7. But the device can just as well be used to inspect other high voltage components, such as the generators 5 or the loads 13.

Due to that the loads 13 are connected between each respective high voltage conductor 7, and thus between the respective phases of the alternating currents, the voltage over the loads is not affected by the displacement of the common potential in the zero point 9. Thus the operation of the loads 13 is not affected and the inspection may be performed at any time during the operation of the high voltage system 1.

The device 3 is further adapted to displace the common potential during a time interval shorter than three minutes. Thus the current through the inhomogenity 25 does not risk enlarging the inhomogenity 25 to such a large degree that a partial discharge occurs when the potential is subsequently lowered. In this example the device is adapted to displace the common potential during a time interval shorter than one minute, more preferably shorter than 30 seconds. In this example the device 3 is further adapted to displace the common potential during a time interval, which is longer than ten seconds.

The potential displacement device 33 comprises a voltage feeder 35 adapted to feed the zero point 9 with a voltage. The voltage feeder 35 thus displaces the common potential for the high voltage system 1. The voltage feeder is adapted to feed a voltage, which is adjustable in relation to phase angle, amplitude and frequency. The voltage feeder 35 is also adapted to feed two or more superposed alternating currents. In this example one of the fed, superposed alternating currents is synchronous with the system voltage.

The potential displacement device 33 further comprises a zero point reactor 37. The zero point reactor 37 comprises a coil and number of capacitors. The reactor 37 is adapted to compensate for a capacitive earth current of the high voltage system 1. Thus the power need for the voltage feeder 35 decreases. Furthermore the reactor 37 is adapted to provide a simple and efficient feeding point for the voltage feeder 35.

The sensor 27 is adapted to detect partial discharges in the high voltage conductor 7 to be inspected. In this example the sensor 27 is adapted to sense an electrical pulse in the screen 19. The pulse originates from a partial discharge in the insulating cover 17 of the high voltage conductor. When a partial discharge occurs temporary pulses occur in the screen 19, which are transmitted through the screen 19 along the length of the high voltage conductor 7. Since the high voltage conductor conducts an alternating current partial discharges occur at each voltage maximum. Thus a sequence of pulses in the screen 19 is created. The sensor 27 is adapted to sense pulses from two different locations along the cable. By comparing the times at which the pulses are detected at the different positions the location of the inhomogenity 25 along the length of the conductor 7 may be calculated. Preferably the sensor 27 comprises two sensors adapted to be connected with one end each of the high voltage conductor 7.

In figure 3a a first example of how the common potential may be displaced is shown. The potential displacement device 33, with the voltage feeder 35 and the reactor 37, is thus adapted to feed an alternating current to the zero point 9 to displace the common potential. The device 3 is further adapted to feed an alternating current, which is mainly in opposite phase relative to the alternating current of a high voltage conductor in order to displace the common potential.

In fig. 3a three dotted vectors 39 are shown, corresponding to the three original alternating current phases in the high voltage system 1. When adding the alternating current phases, that is, by adding the three dotted vectors 39, a common potential 41 in obtained which is close to the earth potential, in this example zero. This zero potential thus corresponds to the zero point 9 in figure 1. In figure 3a it is shown how the common potential is displaced 40 by feeding an alternating current to the zero point which is substantially in opposite phase relative to an alternating current of one of the high voltage conductors. Thus the potential in that high voltage conductor becomes zero, wherein the vector for the high voltage conductor, which is not to be inspected 43, ends up in the zero potential. This is advantageous if the high voltage conductor has been affected by an inhomogenity.

The common potential is further displaced so that the common potential obtains a potential equal to but opposite the previous potential in the high voltage conductor, which is shown at point 45. As apparent in the figure 3a the potential difference relative to the other two high voltage conductors 46 and earth is increased. Thus partial discharges may be obtained for these conductors even for inhomogenities, which are too small to cause partial discharges at a normal potential, which facilitates an inspection of the conductors.

In this example the amplitude of the fed alternating current is mainly of the same size as the amplitude of the original alternating currents in the high voltage conductors 7. The device is thus adapted to displace the common potential so that the maximum potential between the high voltage component which is to be inspected and earth potential has increased more than or equal to one and a half times the original maximum potential. In this example the device 3 is adapted to displace the common potential so that the potential of the second high voltage component, which is not to be inspected, is close to the earth potential. Alternatively the common potential may be displaced with a smaller voltage, wherein the potential of a conductor in which partial discharges has been detected can be decreased, at the same time as the voltage of the other conductors only increases with a smaller part, wherein the probability that partial discharges occur for these conductors only increases with a smaller part.

In one alternative embodiment, which is shown in fig. 3b, the potential displacement device is instead adapted to feed an alternating current, which mainly has the same phase as the alternating current through the high voltage component 7, which is to be inspected, for displacing the common potential. In figure 3b three dotted vectors 47 corresponding to the three original phases of the high voltage system are shown. The three dotted vectors 47 coincide in an earth potential 49. When feeding an alternating current being in the same phase as the phase in the high voltage component, which is to be inspected, and having a corresponding amplitude, a displacement of the common potential to a potential which is equal to the original potential of the high voltage component, which is to be inspected, is achieved, which potential is shown in point 51. The point 51 thus represents the common potential after displacement of the common potential. The displacement is illustrated by the arrow 52. The solid vectors 53 show the phases of the high voltage system after the displacement of the common potential 51. As apparent from figure 3b the potential of the high voltage component to be inspected has increased to twice the original potential. At the same time the potential for the other two high voltage components, which are not to be inspected, remain at the same potential as previously but having another phase.

The examples in fig. 3a and fig. 3b are only chosen for illustrative purposes. In practice the amplitude of the alternating current used to displace the common potential will be lower than the corresponding amplitude of the voltages in the high voltage system. A suitable amplitude, and thus a suitable size for the displacement of the common potential, may be decided by a man skilled in the art departing from what has been shown in this application and commercially available information about the component to be inspected. Furthermore it is possible to displace the common potential with an alternating current having a phase in between the phases of the high voltage system.

The control device 29 is adapted in part to control the potential displacement device 33 and in part to control and receive information from the sensor 27. The control device 29 thus coordinates the sensor 27 and the potential displacement device 33 with each other and is adapted to control the device 3 to perform a number of method steps according to the invention. The device 3 is thus adapted to perform the steps of the method according to the computer program written on the computer readable medium 31.

In figure 4 one example of a method according to the invention is shown, which is possible to perform with the device 3 and the control device 29 according to figure 1.

In a first step 55 the method comprises initiating an inspection of a high voltage system. The initiation may either be automatic, for example after a predetermined time has passed or after some particular event, or the inspection may be initiated manually by an operator.

In a second step 57 the method comprises reading a computer program for controlling and coordinating the inspection from a computer readable medium. The computer readable medium may for example be a hard-disc, a CD- or DVD-disc or similar media. Alternatively the device may be programmed in hardware, wherein it is not necessary to read any program.

In a third step 59 the method comprises displacing the common potential for the high voltage conductors during a progressing operation of the high voltage system, so that the maximum potential difference between the high voltage component to be inspected and the earth potential increases. The common potential is displaced by feeding a voltage and/or current to the high voltage system. In this example the common potential is displaced by feeding an alternating current to a zero point of the high voltage system. In this example the fed alternating current is mainly in opposite phase relative to the alternating current of a second high voltage component, which is not to be inspected. Furthermore the method comprises at least partly compensating for an earth current between the high voltage system and earth by use of a reactor.

The method comprises displacing the common potential so that the maximum potential difference between the high voltage component to be inspected and the earth potential increases to more than or equal to one and a half times the original maximum potential. Furthermore the method comprises that the common potential is displaced so that the potential difference between a second high voltage component, which is not to be inspected, and the earth potential is less than half of the original maximum potential, in this example so that the potential of the second high voltage component, which is not to be inspected, is close to the earth potential. Furthermore the common potential is displaced during a time interval, which is shorter than 3 minutes, preferably shorter than 1 minute and most preferably shorter than 30 seconds.

In a fourth step 61 the method comprises inspection of a possible occurrence of partial discharges in the insulating cover of the high voltage component to be inspected. In this example the high voltage component comprises a conducting screen arranged around the component, which screen substantially is kept at earth potential. The method therefore comprises detection of an electrical pulse in the conducting screen of the high voltage component to be inspected with a sensor, which electrical pulse originates from a partial discharge in the insulation of the high voltage component. In this example the method comprises detection of electrical pulses at a first and a second position respectively, and registering of a first and a second point of time respectively, at which the pulses are registered at each respective position. In this example the pulses are registered at the ends of the high voltage components.

In a fifth step 63 the method comprises analyzing the data obtained from the sensor. The method thus comprises determining if a partial discharge has taken place based on whether an electrical pulse has been registered or not. At registration of an electrical pulse the method further comprises comparing the first and the second points of times and estimating the position of the partial discharge departing from the time difference between the points of time.

If a partial discharge is detected for a high voltage component the method comprises, in a sixth step 69, displacing the common potential so that the potential of the high voltage component, in which the partial discharge has occurred, decreases. In this example the common potential is displaced so that the potential of the high voltage component in which the partial discharge has occurred is less than half of the maximum potential during normal operation for the high voltage component. In this example the potential is close to the earth potential.

The invention is not limited to the embodiments shown herein but may be varied in many ways within the framework of the attached claims.

## Claims

1. A method for facilitating handling a high voltage component in relation to partial discharges in the high voltage component (7), which high voltage component (7) comprises an insulating cover (17) enclosing the component and which high voltage component is connected with a high voltage system (1) comprising two or more high voltage conductors adapted to each conduct an electric alternating current, which alternating currents are adapted relative to each other in size and phase, so that the alternating currents added together substantially cancel each other in a common potential, which is close to the earth potential, which method comprises:
- jointly displacing the common potential for the high voltage conductors during progressing high-voltage operation of the high voltage system, wherein the voltage oscillates around an average potential.

2. A method according to claim 1, **characterized in that** the method comprises displacing the common potential so that the potential difference between the high voltage component and the earth potential decreases, if a partial discharge is detected in the high voltage component.

3. A method according to claim 1, **characterized in that** the common potential is displaced so that a maximum potential difference between the high voltage component to be inspected and the earth potential increases, wherein the method comprises
- inspection for a possible occurrence of partial discharges in the insulating cover (17) of the high voltage component to be inspected.

4. A method according to claim 3, **characterized in that** the common potential is displaced so that the maximum potential difference between the high voltage component (7), which is to be inspected, and the earth potential increases until a partial discharge is detected.

5. A method according to any of the claims 2-4, **characterized in that** the method comprises detecting an electrical pulse in the high voltage component, which is to be inspected, which electrical pulse originates from a partial discharge in the insulation of the high voltage component.

6. A method according to any of the previous claims, **characterized in that** the common potential is displaced by feeding a voltage and/or current to the high voltage system.

7. A method according to claim 6, **characterized in that** the common potential is displaced by feeding an alternating current to a zero point (9) of the high voltage system.

8. A method according to any of the previous claims, **characterized in that**, if a partial discharge is detected for a high voltage component, the method comprises displacement of the common potential so that the potential of the high voltage component is close to the earth potential.

9. A device adapted to be connected with a high voltage system (1) comprising a high voltage component (7) enclosed by an insulating cover (17) and two or more high voltage conductors adapted to each conduct an alternating electric current, which alternating currents are adapted relative to each other in size and phase, so that the currents added together substantially cancel each other in a common potential which is close to the earth potential, **characterized in that** the device (3) is adapted to, during a progressing high-voltage operation of the high voltage system, achieve a joint displacement of the common potential for the high voltage conductors, while the voltage oscillates around an average potential.

10. A device according to claim 9, **characterized in that** the device is adapted to displace the common potential, so that the potential difference between a high voltage component (7) and the earth potential decreases, if a partial discharge has been detected **in that** high voltage component.

11. A device according to claim 9, **characterized in that** the device is adapted to achieve a common displacement of the common potential for the high voltage conductors so that the potential difference between the high voltage component and earth increases, wherein an inspection of a possible occurrence of partial discharges through the insulating cover (17) of the high voltage component is facilitated.

12. A device according to claim 11, **characterized in that** the device is adapted to displace the common potential so that the maximum potential difference between the high voltage component to be inspected and the earth potential increases until a partial discharge has been detected.

13. A device according to any of the claims 9-12, **characterized in that** the device comprises a voltage feeder (35) adapted to feed a voltage and/or current to the high voltage system in order to displace the common potential.

14. A device according to claim 13, **characterized in that** the voltage feeder (35) is adapted to feed an alternating current to a zero point (9) of the high voltage system in order to displace the common potential.

15. A device according to any of the claims 9-14, **characterized in that** the device comprises a sensor (27) adapted to detect an electrical pulse in the high voltage component to be inspected, which electrical pulse originates from a partial discharge in the insulation of the high voltage component.

## Patentansprüche

1. Ein Verfahren zur Erleichterung der Handhabung einer Hochspannungskomponente in Bezug auf teilweise Entladungen in der Hochspannungskomponente (7), wobei die Hochspannungskomponente (7) aufweiset
ein isolierendes Gehäuse (17) einschließend die Komponente und wobei die Hochspannungskomponente verbunden ist mit einem Hochspannungssystem (1) aufweisend
zwei oder mehrere Hochspannungsleitungen angepasst jeweils zum Führen des elektrischen Wechselstroms, wobei die Wechselströme angepasst sind relativ zueinander in Größe und Phase, so dass sich die Wechselströme, wenn sie addiert werden, sich im Wesentlichen auslöschen in einem gemeinsamen Potential, welches nahe dem Erdungspotential ist, wobei das Verfahren aufweist:
gemeinschaftliches Verschieben des gemeinsamen Potentials für die Hochspannungsleitungen während des Durchführens des Hochspannungsbetriebes von dem Hochspannungssystem, wobei die Spannung um ein mittleres Potential oszilliert.

2. Ein Verfahren nach Anspruch 1, **gekennzeichnet dadurch, dass** das Verfahren aufweist Verschieben des gemeinsamen Potentials, so dass sich die Potentialdifferenz zwischen der Hochspannungskomponente und dem Erdungspotential verringert, wenn eine teilweise Entladung erkannt wird in der Hochspannungskomponente.

3. Ein Verfahren nach Anspruch 1, **gekennzeichnet dadurch, dass** das gemeinsame Potential verschoben wird, so dass sich eine maximale Potentialdifferenz zwischen der zu inspizierenden Hochspannungskomponente und dem Erdungspotential erhöht, wobei das Verfahren aufweist Inspizieren für einen möglichen Auftritt einer teilweisen Entladung in dem isolierenden Gehäuse (17) von der Hochspannungskomponente die inspiziert werden soll.

4. Ein Verfahren nach Anspruch 3, **gekennzeichnet dadurch, dass** das gemeinsame Potential verschoben wird, so dass sich die maximale Potentialdifferenz zwischen der Hochspannungskomponente (7) die inspiziert werden soll und dem Erdungspotential erhöht, bis eine teilweise Entladung erkannt wird.

5. Das Verfahren nach einem der Ansprüche 2 bis 4, **gekennzeichnet dadurch, dass** das Verfahren aufweist, Erkennen eines elektrischen Pulses in der Hochspannungskomponente die inspiziert werden soll, wobei der elektrische Puls ausgeht von einer teilweisen Entladung in der Isolierung von der Hochspannungskomponente.

6. Ein Verfahren nach einem der vorherigen Ansprüche, **gekennzeichnet dadurch, dass** das gemeinsame Potential verschoben wird durch Zuführen einer Spannung und/oder eines Stroms an das Hochspannungssystem.

7. Das Verfahren nach Anspruch 6 **gekennzeichnet dadurch, dass** das gemeinsame Potential verschoben wird durch Zuführen einer Wechselspannung an einen Nullpunkt (9) von dem Hochspannungssystem.

8. Ein Verfahren nach einem der vorherigen Ansprüche, **gekennzeichnet dadurch, dass** wenn eine teilweise Entladung erkannt wird für eine Hochspannungskomponente, das Verfahren aufweist, Verschieben von dem gemeinsamen Potential, so dass das Potential von der Hochspannungskomponente nahe dem Erdungspotential ist.

9. Ein Gerät angepasst um verbunden zu werden mit einem Hochspannungssystem (1) aufweisend eine Hochspannungskomponente (7) eingeschlossen durch ein isolierendes Gehäuse (17) und zwei oder mehrere Hochspannungsleitungen angepasst jede zum Leiten eines elektrischen Wechselstroms, die Wechselströme sind angepasst relativ zueinander in Größe und Phase, so dass die Ströme, wenn diese addiert werden, sich im Wesentlichen auslöschen in einem gemeinsamen Potential, welches nahe dem Erdungspotential ist, **gekennzeichnet dadurch, dass** das Gerät (3) angepasst ist, während der Durchführung eines Hochspannungsbetriebes von dem Hochspannungssystem ein gemeinschaftliche Verschiebung von dem gemeinsamen Potential für die Hochspannungsleitungen zu erreichen, während die Spannung um ein mittleres Potential oszilliert.

10. Das Gerät nach Anspruch 9, **gekennzeichnet dadurch, dass** das Gerät angepasst ist zum Verschieben des gemeinsamen Potentials, so dass sich die Potentialdifferenz zwischen einer Hochspannungskomponente (7) und dem Erdungspotential verringert, wenn eine teilweise Entladung erkannt wurde in der Hochspannungskomponente.

11. Ein Gerät nach Anspruch 9, **gekennzeichnet dadurch, dass** das Gerät angepasst ist zum Erreichen einer gemeinschaftlichen Verschiebung von dem gemeinsamen Potential für die Hochspannungsleitungen, so dass sich die Potentialdifferenz zwischen der Hochspannungskomponente (7) und der Erde erhöht, wobei eine Inspektion von einem möglichen Auftritt von teilweisen Entladungen durch das isolierende Gehäuse (17) von der Hochspannungskomponente erleichtert wird.

12. Das Gerät nach Anspruch 11, **gekennzeichnet dadurch, dass** das Gerät angepasst ist zum Verschieben des gemeinsamen Potentials, so dass sich die maximale Potentialdifferenz zwischen der Hochspannungskomponente die inspiziert werden soll und dem Erdungspotential erhöht, bis eine teilweise Entladung erkannt wurde.

13. Ein Gerät nach einem der Ansprüche 9 bis 12, **gekennzeichnet dadurch, dass** das Gerät aufweiset einen Spannungszuführer (35) angepasst zum Zuführen einer Spannung und/oder eines Stroms an das Hochspannungssystem, um das gemeinsame Potential zu verschieben.

14. Ein Gerät nach Anspruch 13, **gekennzeichnet dadurch, dass** der Spannungszuführer (35) angepasst ist zum Zuführen eines Wechselstroms an einen Nullpunkt (9) von dem Hochspannungssystem, um das gemeinsame Potential zu verschieben.

15. Ein Gerät nach einem der Ansprüche 9 bis 14, **gekennzeichnet dadurch, dass** das Gerät aufweiset einen Sensor (27) angepasst zum Erkennen eines elektrischen Pulses in der Hochspannungskomponente die inspiziert werden soll, wobei der elektrische Puls ausgeht von einer teilweisen Entladung in der Isolierung von der Hochspannungskomponente.

## Revendications

1. Procédé de facilitation de manipulation d'un composant haute tension vis-à-vis de décharges partielles dans ledit composant haute tension (7), lequel composant haute tension (7) comprend un couvercle isolant (17) renfermant le composant et lequel composant haute tension est connecté à un système haute tension (1) comprenant au moins deux conducteurs haute tension adaptés de telle sorte que chacun d'entre eux conduisent un courant électrique alternatif, lesquels courants alternatifs sont adaptés les uns par rapport aux autres en valeur et en phase, afin qu'additionnés, lesdits courants alternatifs s'annulent substantiellement les uns les autres dans un potentiel commun proche du potentiel de la terre, lequel procédé comprend :
- le déplacement conjoint du potentiel commun des conducteurs haute tension durant le fonctionnement à haute tension en cours du système haute tension, où la tension oscille autour d'un potentiel moyen.

2. Procédé selon la revendication 1, **caractérisé en ce que** ledit procédé comprend le déplacement du potentiel commun de telle sorte que la différence de potentiel entre le composant haute tension et le potentiel de la terre diminue, si une décharge partielle est détectée dans le composant haute tension.

3. Procédé selon la revendication 1, **caractérisé en ce que** le potentiel commun est déplacé de telle sorte qu'une différence de potentiel maximale entre le composant haute tension à inspecter et le potentiel de la terre augmente, où le procédé comprend :
- l'inspection de la possibilité de décharges partielles dans le couvercle isolant (17) du composant haute tension à inspecter.

4. Procédé selon la revendication 3, **caractérisé en ce que** le potentiel commun est déplacé de telle sorte que la différence de potentiel maximale entre le composant haute tension (7) à inspecter et le potentiel de la terre augmente jusqu'à ce qu'une décharge partielle soit détectée.

5. Procédé selon l'une quelconque des revendications 2 à 4, **caractérisé en ce que** le procédé comprend la détection d'une impulsion électrique dans le composant haute tension, qui est à inspecter, laquelle impulsion électrique est créée par une décharge partielle dans l'isolation du composant haute tension.

6. Procédé selon l'une des revendications précédentes, **caractérisé en ce que** le potentiel commun est déplacé en alimentant le système haute tension d'une tension et/ou d'un courant.

7. Procédé selon la revendication 6, **caractérisé en ce que** le potentiel commun est déplacé en alimentant un point zéro (9) du système haute tension d'un courant alternatif.

8. Procédé selon l'une des revendications précédentes, **caractérisé en ce que**, si une décharge partielle est détectée pour un composant haute tension, ledit procédé comprend le déplacement du potentiel commun de telle sorte que le potentiel du composant haute tension soit proche du potentiel de la terre.

9. Dispositif adapté pour être connecté à un système haute tension (1) comprenant un composant haute tension (7) enfermé dans un couvercle isolant (17) et au moins deux conducteurs haute tension adaptés afin que chacun conduise un courant électrique alternatif, lesquels courants alternatifs sont adaptés l'un par rapport à l'autre en valeur et en phase, afin que lesdits courants une fois additionnés ensemble s'annulent substantiellement l'un l'autre dans un potentiel commun proche du potentiel de la terre, **caractérisé en ce que** le dispositif (3) est adapté pour, au cours d'un fonctionnement en haute tension du système haute tension, effectuer un déplacement joint du potentiel commun pour les conducteurs haute tension, tandis que la tension oscille autour d'une potentiel moyen.

10. Dispositif selon la revendication 9, **caractérisé en ce que** ledit dispositif est adapté pour déplacer le potentiel commun, de telle sorte que la différence de potentiel entre un composant haute tension (7) et le potentiel de la terre diminue, si une décharge partielle a été détectée dans le composant haute tension.

11. Dispositif selon la revendication 9, **caractérisé en ce que** ledit dispositif est adapté pour réaliser un déplacement du potentiel commun pour les conducteurs haute tension de telle sorte que la différence de potentiel entre le composant haute tension et la terre augmente, où l'inspection de possibles décharges à travers le couvercle isolant (17) du composant haute tension est facilitée.

12. Dispositif selon la revendication 11, **caractérisé en ce que** ledit dispositif est adapté pour déplacer le potentiel commun, de telle sorte que la différence de potentiel maximale entre le composant haute tension à inspecter et le potentiel de la terre augmente jusqu'à ce qu'une décharge partielle soit détectée.

13. Dispositif selon l'une quelconque des revendications 9 à 12, **caractérisé en ce que** ledit dispositif comprend une alimentation en tension (35) adapté pour alimenter le système haute tension en tension et/ou en courant afin de déplacer le potentiel commun.

14. Dispositif selon la revendication 13, **caractérisé en ce que** l'alimentation en tension (35) est adaptée pour fournir un courant alternatif à un point zéro (9) du système haute tension afin de déplacer le potentiel commun.

15. Procédé selon l'une quelconque des revendications 9 à 14, **caractérisé en ce que** le dispositif comprend un capteur (27) adapté pour détecter une impulsion électrique dans le composant haute tension à inspecter, laquelle impulsion électrique est créée par une décharge partielle dans l'isolation du composant haute tension.
